# FASCICULE DE BREVET EUROPEEN

(11) **EP 1 635 501 B1**
(45) Date de publication et mention de la délivrance du brevet: **14.11.2007**
(21) Numéro de dépôt: 05291866.1
(22) Date de dépôt: 08.09.2005
(51) Int. Cl.: H04L 7/00, H04L 7/02, H04J 3/04, H03K 5/26, H04N 7/62

(54) **Procédé de détection du positionnement relatif de deux signaux et dispositif correspondant**
Verfahren zur Ermittlung der relativen Lage von zwei Signalen und entsprechende Vorrichtung
Method of detecting the relative position of two signals and corresponding device

(30) Priorité: 14.09.2004 FR 0409735
(43) Date de publication de la demande: 15.03.2006
(73) Titulaire: STMicroelectronics SA, 92120 Montrouge (FR)
(72) Inventeur: Cauchy, Xavier, 38190 Laval (FR); Salvaire, Eric, 38000 Grenoble (FR); Force, Eric, 38100 Grenoble (FR)
(74) Mandataire: Casalonga, Axel

(56) Documents cités:
- EP-A- 1 146 413
- US-B1- 6 175 603

## Description

L'invention concerne la détection du positionnement relatif de deux signaux, en particulier de deux signaux d'horloge.

L'invention s'applique avantageusement mais non limitativement à la transmission de données entre deux domaines d'horloge.

Lors de la transmission des données, l'objectif est de connaître le positionnement relatif des signaux d'horloge de chaque domaine, la fréquence de l'un des signaux d'horloge étant n fois supérieure à la fréquence de l'autre signal d'horloge, avec n entier. Autrement dit, le but est de savoir comment se situe un front du signal d'horloge ayant la fréquence la plus élevée par rapport au front du signal d'horloge ayant la fréquence la plus faible ou vice-versa.

En effet, si l'on veut transmettre, par exemple, des informations du domaine cadencé par l'horloge ayant la fréquence la plus élevée au domaine cadencé par l'horloge ayant la fréquence la plus faible, il est préférable d'effectuer la transmission sur le premier front du signal de l'horloge à fréquence élevée correspondant à un front du signal de l'horloge à faible fréquence. On bénéficie ainsi de plus de temps pour effectuer la transmission de données, limitant de ce fait les risques de perte de données.

Un procédé connu pour détecter le positionnement relatif des fronts horloges de deux horloges de fréquences différentes, propose d'échantillonner l'horloge dite lente avec l'horloge dite rapide. De cette manière, on peut savoir pendant quel cycle de l'horloge rapide, a lieu le changement de niveau de l'horloge lente.

Cependant, une telle solution engendre des problèmes de stabilité du fait que l'on échantillonne un signal d'horloge à l'aide d'un signal d'une autre horloge. De plus, la solution de l'art antérieur complique fortement la gestion du domaine de l'horloge.

Le document EP 1146413 propose un dispositif pour convertir un signal d'horloge en un signal de données qui imite le comportement du signal d'horloge.

L'invention vise à apporter une solution à ces problèmes.

L'invention propose un procédé de détection du positionnement relatif de deux signaux d'horloge, l'un de ces signaux d'horloge étant un signal d'horloge dite rapide et l'autre un signal d'horloge dite lente, tel que la fréquence de l'horloge rapide soit n fois supérieure à la fréquence de l'horloge lente, n étant un entier supérieur à 1. On génère à partir des signaux d'horloge, un signal logique dit de phase prenant une valeur logique prédéterminée lorsqu'un front montant du signal d'horloge rapide se situe à un emplacement prédéterminé de la période du signal d'horloge lente.

Autrement dit, on crée un signal indépendant des deux signaux d'horloge, dont la valeur indique le moment où le front montant de l'une des deux horloges se situe à un emplacement prédéterminé de la période de l'autre horloge ; par exemple, lorsqu'un front de l'une des deux horloges est aligné avec un front de l'autre horloge.

Ce procédé a notamment pour avantage, en utilisant un signal auxiliaire indépendant des deux signaux d'horloge, de respecter les règles des techniques de conception d'un circuit intégré.

Les fronts des deux signaux sont de préférence sensiblement alignés. Cela étant l'invention permet également d'utiliser des signaux non-alignés.

Selon un mode de mise en oeuvre, la génération du signal logique de phase comprend :
- un auto échantillonnage de l'un des signaux d'horloge de façon à obtenir un premier signal logique intermédiaire,
- un échantillonnage du premier signal logique intermédiaire, à l'aide de l'autre signal d'horloge de façon à obtenir un second signal logique intermédiaire,
- et une opération logique sur les deux signaux intermédiaires de façon à obtenir un signal logique dit de phase.

L'opération logique peut être une opération « OU EXCLUSIF ».

L'invention propose également un dispositif pour la détection du positionnement relatif de deux signaux d'horloge, l'un de ces signaux d'horloge étant un signal d'horloge dite rapide et l'autre un signal d'horloge dite lente, tel que la fréquence de l'horloge rapide soit n fois supérieure à la fréquence de l'horloge lente, n étant un entier supérieur à 1. Le dispositif comprend des moyens de génération aptes à élaborer, à partir des signaux d'horloge, un signal logique dit de phase prenant une valeur logique prédéterminée lorsqu'un front montant du signal d'horloge rapide se situe à un emplacement prédéterminé de la période du signal d'horloge lente.

Le premier et le deuxième élément séquentiel peuvent être des bascules.

Selon un mode de réalisation, le dispositif comprend une porte logique « OU EXCLUSIF ».

L'invention propose également un système de multiplexage contrôlé de données, comprenant un dispositif pour la détection du positionnement relatif de deux signaux d'horloge tels que défini ci-avant, comprenant en outre :
- un nombre p d'éléments séquentiels d'entrée cadencés par le signal d'horloge lente et respectivement connectés à un multiplexeur commandé par un signal de commande par l'intermédiaire d'un compteur modulo-p, ledit compteur modulo-p étant cadencé par le signal d'horloge rapide et commandé par le signal logique de phase,
- un élément séquentiel de sortie cadencé par le signal d'horloge rapide et recevant en entrée le signal de sortie du multiplexeur.

En outre, les moyens de génération comprennent avantageusement :
- un premier élément séquentiel dont la sortie est rebouclée sur l'entrée, cadencé par l'un des signaux d'horloge, et apte à délivrer un premier signal logique intermédiaire,
- un deuxième élément séquentiel alimenté par le premier signal logique intermédiaire, cadencé par le signal issu de l'autre horloge, et apte à délivrer un deuxième signal logique intermédiaire,
- un élément logique connecté à la sortie des deux éléments séquentiels.

Le premier et le deuxième élément séquentiel peuvent être des bascules.

L'élément logique peut être une porte logique « OU EXCLUSIF ».

Les applications d'un dispositif selon l'invention sont nombreuses. On en cite maintenant quelques unes à titre illustratif mais non limitatif.

Plus précisément l'invention propose également, un système de transmission synchronisée de données comprenant :
- un dispositif pour la détection du positionnement relatif de deux signaux d'horloge, tel que défini ci-dessus,
- un élément séquentiel d'entrée cadencée par l'un des signaux d'horloge et dont la sortie est rebouclée sur l'entrée par l'intermédiaire d'un sélecteur commandé par le signal logique dit de phase délivré par ledit dispositif de détection, ledit sélecteur recevant également en entrée lesdites données à transmettre,
- un élément séquentiel de sortie recevant en entrée le signal délivré en sortie de l'élément séquentiel d'entrée et cadencé par l'autre signal d'horloge.

Par ailleurs, l'invention propose également un système de multiplexage contrôlé de données, comprenant :
- un dispositif pour la détection du positionnement relatif de deux signaux d'horloge tel que défini ci-dessus,
- p d'éléments séquentiels d'entrée cadencés par le signal d'horloge lente et respectivement connectés à un multiplexeur commandé par un signal de commande par l'intermédiaire d'un compteur modulo-p, ledit compteur modulo-p étant cadencé par le signal d'horloge rapide et commandé par le signal logique dit de phase délivré par ledit dispositif de détection,
- un élément séquentiel de sortie cadencé par le signal d'horloge rapide et recevant en entrée le signal de sortie du multiplexeur.

L'invention propose encore un système de filtres polyphasés, comprenant :
- un dispositif pour la détection du positionnement relatif de deux signaux d'horloge tel que défini ci-dessus,
- un élément séquentiel d'entrée recevant des données d'entrée, cadencé par le signal de l'horloge lente,
- un multiplexeur destiné à recevoir en parallèle n coefficients prédéterminés,
- un moyen de mélange dont la sortie est connectée à l'entrée d'un additionneur et apte à recevoir les n coefficients prédéterminés délivrés par le multiplexeur,
- un compteur modulo-n, commandé par le signal logique de phase délivré par ledit dispositif de détection, et cadencé par le signal d'horloge rapide, pour commander le multiplexeur de façon à ordonnancer la délivrance des n coefficients prédéterminés,
- un élément séquentiel de sortie connecté à la sortie du multiplexeur et cadencé par le signal d'horloge rapide.

D'autres avantages et caractéristiques de l'invention apparaîtront à l'examen de la description détaillée de plusieurs modes de réalisation de l'invention nullement limitatifs, et des dessins annexés sur lesquels :
- la figure 1 représente des signaux d'horloge définissant deux domaines d'horloge, n étant égal à 2 dans cet exemple,
- la figure 2 représente un premier mode de réalisation d'un dispositif de détection du positionnement relatif de deux signaux d'horloge selon l'invention, fonctionnant pour n=2
- la figure 3 représente des signaux mis en oeuvre par le dispositif représenté sur la figure 2,
- la figure 4 représente un deuxième mode de réalisation d'un dispositif de détection du positionnement relatif de deux signaux d'horloge selon l'invention, fonctionnant pour n quelconque,
- la figure 5 représente des signaux mis en oeuvre dans le système représenté sur la figure 4,
- la figure 6 représente un exemple d'application du dispositif représenté sur les figures 2 ou 4,
- la figure 7 représente des signaux mis en oeuvre dans le système représenté sur la figure 6,
- la figure 8 représente un autre exemple d'application du dispositif représenté sur la figure 4,
- la figure 9 représente un autre exemple d'application du dispositif représenté sur la figure 4.

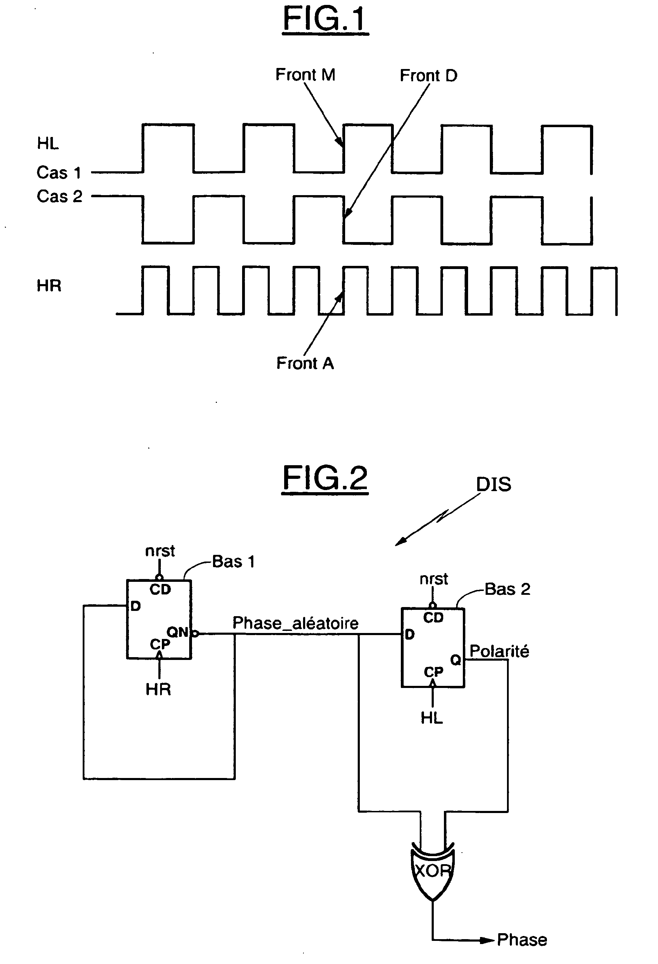

La figure 1 représente deux signaux d'horloge HL et HR, définissant deux domaines d'horloge distincts, dans le cas où le signal HL est deux fois plus rapide que le signal HR (n=2). On considère par exemple, pour le signal d'horloge HL deux cas différents. Le cas 1 illustre une première configuration où les deux horloges sont actives sur des fronts de même polarité, c'est-à-dire qu'à un front montant A de l'horloge rapide HR correspond un front montant M de l'horloge lente HL. Le cas 2 illustre une autre configuration où les deux horloges sont actives sur des fronts de polarités opposées c'est-à-dire qu'à un front montant A de l'horloge rapide HR correspond un front descendant D de l'horloge lente HL.

Dans l'exemple illustré sur la figure 1, les deux signaux d'horloge HL et HR sont alignés, c'est-à-dire qu'un front du signal d'horloge Front A, correspond à un front du signal d'horloge HL. Cependant, lors de la réalisation du circuit, la technologie des composants électroniques utilisés peuvent générer un décalage entre les fronts des signaux d'horloge.

En outre, la fréquence du signal d'horloge HR est n fois plus élevée que la fréquence du signal d'horloge HL. Dans cet exemple, on prendra n=2. Cependant, n peut être un entier quelconque supérieur à 1.

On se réfère à présent à la figure 2 qui représente un dispositif DIS selon l'invention. Le dispositif DIS comprend un premier élément séquentiel Bas 1, qui peut être par exemple une bascule D. On considèrera par la suite, que les éléments séquentiels utilisés dans les exemples décrits sont des bascules commandées par un signal de remise à zéro nrst.

La bascule Bas 1 est cadencée par le signal d'horloge rapide HR, c'est-à-dire le signal d'horloge ayant la fréquence la plus élevée, représentée sur la figure 1. Par ailleurs, la sortie QN de la bascule Bas 1 est rebouclée sur son entrée D. La bascule Bas 1 délivre en sortie un premier signal logique intermédiaire Phase_aléatoire.

Le dispositif DIS comprend également un deuxième élément séquentiel Bas 2. La bascule Bas 2 est cadencée par le signal d'horloge dite lente HL, c'est-à-dire le signal d'horloge ayant la fréquence la moins élevée. Pour ce dispositif, la fréquence de l'horloge rapide HR doit être deux fois plus rapide que celle de l'horloge lente HL (n=2). L'entrée D de la deuxième bascule Bas 2 est connectée à la sortie QN de la première bascule Bas 1. La deuxième bascule Bas 2 reçoit donc en entrée le signal logique intermédiaire Phase_aléatoire. Par ailleurs, la deuxième bascule Bas 2 délivre par sa borne de sortie Q un second signal logique intermédiaire Polarité. Les premier et deuxième signaux logiques intermédiaires, Phase_aléatoire et Polarité sont délivrés en entrée d'une porte logique OU EXCLUSIF, XOR. La porte logique XOR délivre alors un signal de sortie Phase, en fonction des deux signaux d'entrée Phase_aléatoire et Polarité.

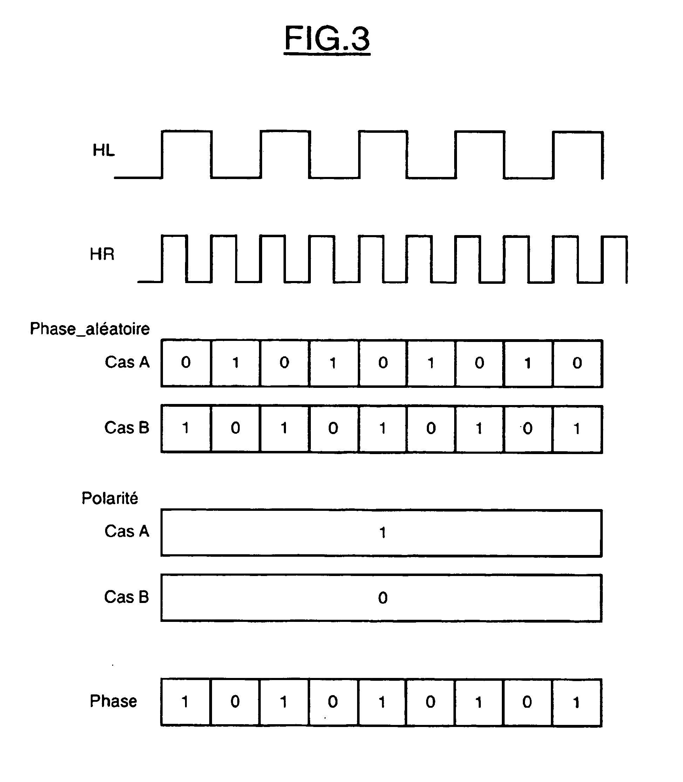

On se réfère à présent à la figure 3 qui décrit l'évolution des signaux mis en oeuvre dans le dispositif DIS de la figure 2. Les signaux d'horloge rapide HR et lente HL sont les signaux représentés sur la figure 1. La fréquence du signal d'horloge rapide HR est, dans cet exemple, deux fois plus élevée que la fréquence du signal d'horloge lente HL. On considère deux cas distincts concernant les valeurs prises par le signal Phase_aléatoire. Le cas A représente la situation où la première valeur prise par le signal Phase_aléatoire est « 0 ». Dans ce cas, le signal Phase_aléatoire prend successivement les valeurs « 0 » puis « 1 » à la fréquence du signal d'horloge rapide HR. Le cas B représente la situation où la première valeur prise par le signal Phase_aléatoire est « 1 ». Dans ce cas, le signal Phase_aléatoire prend successivement les valeurs « 1 » puis « 0 », à la fréquence du signal d'horloge rapide HR.

Selon que les valeurs du signal Phase_aléatoire suivent le cas A ou le cas B, le signal généré par la bascule Bas 2, Polarité, évolue selon deux cas, le cas A ou le cas B. Le signal Polarité évolue selon le cas A si le signal Phase_aléatoire évolue également selon le cas A. Dans ce cas, le signal Polarité prend la valeur « 1 » quelle que soit la valeur du signal Phase_aléatoire. Le signal Polarité évolue selon le cas B si le signal Phase_aléatoire évolue également selon le cas B. Dans ce cas, le signal Polarité prend la valeur « 0 » quelle que soit la valeur prise par le signal Phase_aléatoire. Le signal Phase est généré par la porte logique « OU EXCLUSIF », XOR. On rappelle que selon la table de vérité de la fonction « OU EXCLUSIF », le signal de sortie vaut « 1 » si les deux signaux d'entrée sont dans un état différent. Sinon, le signal de sortie vaut « 0 » si les deux signaux d'entrée sont dans un état identique.

Ainsi, quel que soit le cas de l'évolution des valeurs des signaux Phase_aléatoire et Polarité, le cas A ou le cas B , l'évolution du signal Phase est la même, c'est-à-dire qu'il prend successivement les valeurs « 1 » puis « 0 ». Selon les hypothèses définies pour le mode de réalisation illustré, la valeur logique « 1 » signifie qu'un front montant du signal d'horloge rapide HR correspondant à un front montant du signal de l'horloge lente HL.

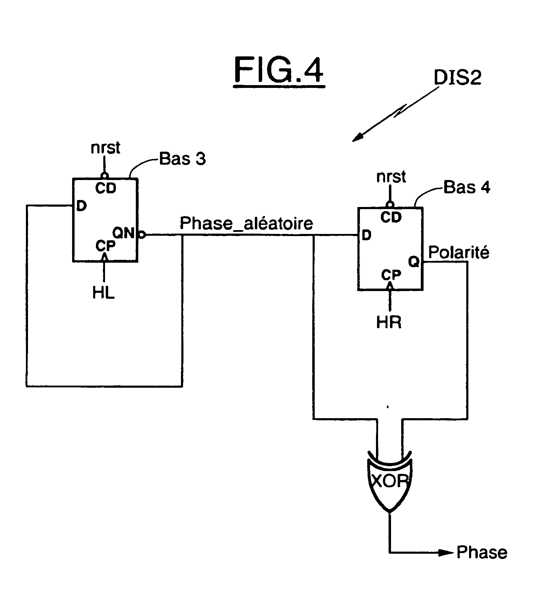

On se réfère à présent à la figure 4 qui représente une variante du dispositif illustré sur la figure 2, fonctionnant avec un rapport n quelconque entre les deux horloges. Le premier élément séquentiel Bas 3 du dispositif DIS 2 de la figure 4 est cadencé par le signal d'horloge lente HL. Le deuxième élément séquentiel Bas 4 est cadencé par le signal d'horloge rapide HR. Ainsi, le rôle des deux éléments séquentiels du dispositif DIS de la figure 2 ont été inversés.

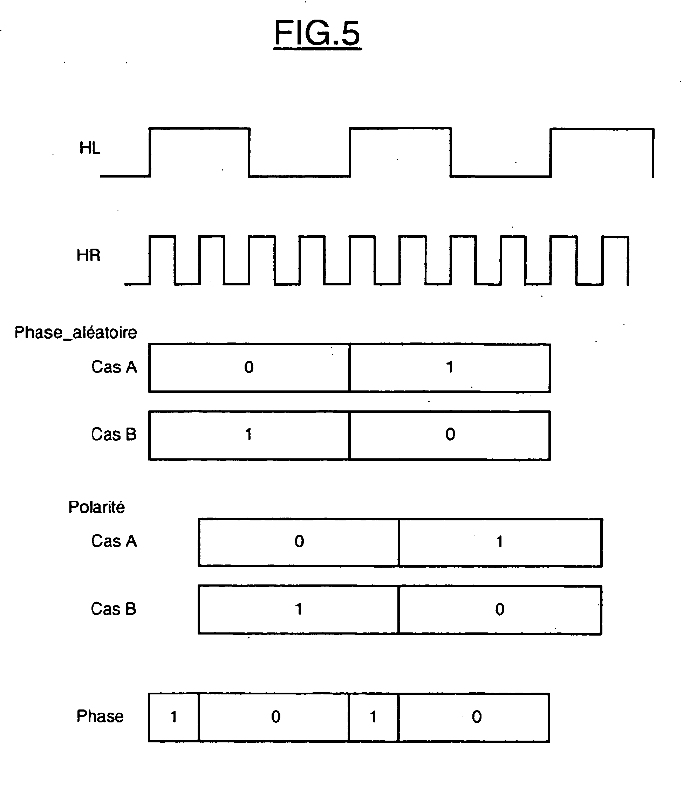

On se réfère à présent à la figure 5 qui illustre l'évolution des signaux mis en oeuvre dans la variante représentée sur la figure 4. Les signaux d'horloge lente HL et rapide HR sont générés tels que la fréquence du signal d'horloge rapide HR soit trois fois plus élevée que la fréquence du signal de l'horloge lente HL. Le signal Phase_aléatoire peut évoluer selon deux cas distincts, le premier cas illustre la situation où la première valeur prise par le signal Phase_aléatoire est « 0 ». Dans ce cas, le signal Phase_aléatoire prend successivement les valeurs « 0 » puis « 1 » à la fréquence du signal de l'horloge lente HL, qui cadence le premier élément séquentiel Bas 3. Si le signal Phase_aléatoire évolue selon le cas B, alors il prend successivement les valeurs « 1 » puis « 0 » à la fréquence du signal d'horloge HL.

De même que pour le dispositif DIS de la figure 2, le signal Polarité évolue également selon deux cas, le cas A et le cas B, respectivement associés au cas A et au cas B du signal Phase_aléatoire. Si le signal Polarité évolue selon le cas A, alors il prend successivement les valeurs « 0 » puis « 1 » à la fréquence du signal de l'horloge lente HL. À l'inverse, si le signal Polarité évolue selon le cas B, alors il prend successivement les valeurs « 1 » puis « 0 » à la fréquence du signal de l'horloge lente HL.

Ainsi, quel que soit le cas selon lequel évoluent les signaux Phase_aléatoire et Polarité, le signal Phase généré par la porte logique « OU EXCLUSIF », XOR, prend la valeur « 1 » lorsqu'un front montant du signal de l'horloge rapide HR correspond à un front montant du signal de l'horloge lente HL, puis la valeur « 0 » sinon.

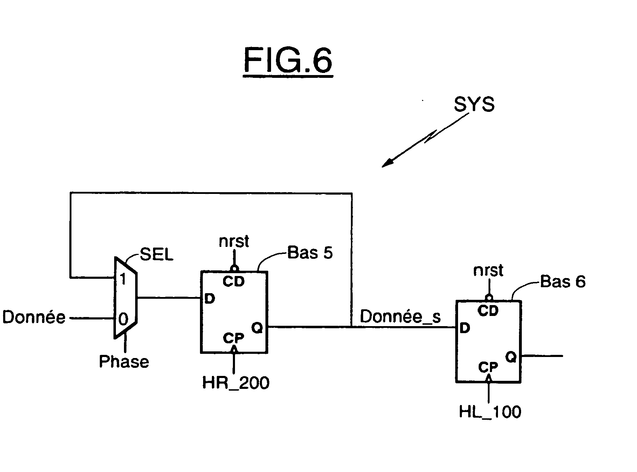

Un premier exemple d'utilisation du dispositif DIS représenté sur la figure 2 est illustré sur la figure 6. On considère dans cet exemple, que l'on utilise deux signaux d'horloge, un premier signal d'horloge dite rapide H_200 dont la fréquence est de 200 MHz et un second signal d'horloge dite lente H_100 dont la fréquence est de 100 MHz.

Le système SYS représente un système de transmission synchronisée de données entre deux domaines de fréquences différentes. Une bascule d'entrée Bas 5 est cadencée par le signal d'horloge rapide HR_200. La bascule Bas 5 est également commandée par un signal de remise à zéro nrst. La sortie Q de la bascule Bas 5 est rebouclée sur son entrée D par l'intermédiaire d'un sélecteur SEL qui reçoit également en entrée des données Données. Par ailleurs, le sélecteur SEL est commandé par un signal de commande qui est le signal logique dit de Phase, généré par le dispositif DIS représenté sur la figure 2. Selon la valeur du signal logique Phase, le sélecteur SEL transmet à l'entrée D de la bascule Bas 5 les données Données. La bascule Bas 5 délivre par sa sortie Q des données Données_s.

La sortie Q de la bascule Bas 5 est également connectée sur l'entrée D d'une bascule de sortie Bas 6, commandée par un signal de remise à zéro nrst. La bascule Bas 6 est cadencée par le signal d'horloge lente HL_100.

La bascule Bas 6 reçoit en entrée les données Données_s délivrées par la sortie Q de la bascule Bas 5. Ainsi, grâce au système SYS, on peut contrôler le fait qu'à chaque coup d'horloge du signal de l'horloge rapide HR, les données puissent être délivrées pour que le temps disponible lors de l'échange de données soit le plus important possible.

En d'autres termes, on garantit un cycle de n période du signal d'horloge la plus rapide, (dans cet exemple n est égal à 2), pour permettre l'échange des données.

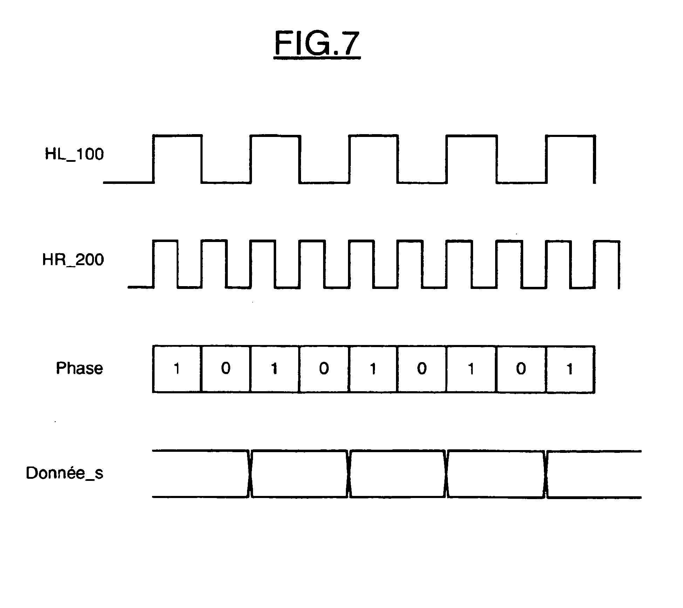

Si l'on se réfère à la figure 7, qui illustre les signaux mis en oeuvre dans le système SYS de la figure 6, on peut voir les signaux d'horloge HL_100 et HR_200, tels que la fréquence du signal d'horloge HR_200 soit de 200 MHz et celle du signal de l'horloge HL_100 soit de 100 MHz. Le signal Phase prend successivement les valeurs « 1 » puis « 0 ». Lorsque le signal Phase prend la valeur « 1 », un front montant du signal d'horloge HR_200 correspond à un front montant du signal d'horloge HL_100. Ainsi, les données Données_s sont échangées lorsqu'un front montant du signal de l'horloge rapide HR_200 correspond à un front montant du signal d'horloge HL_100.

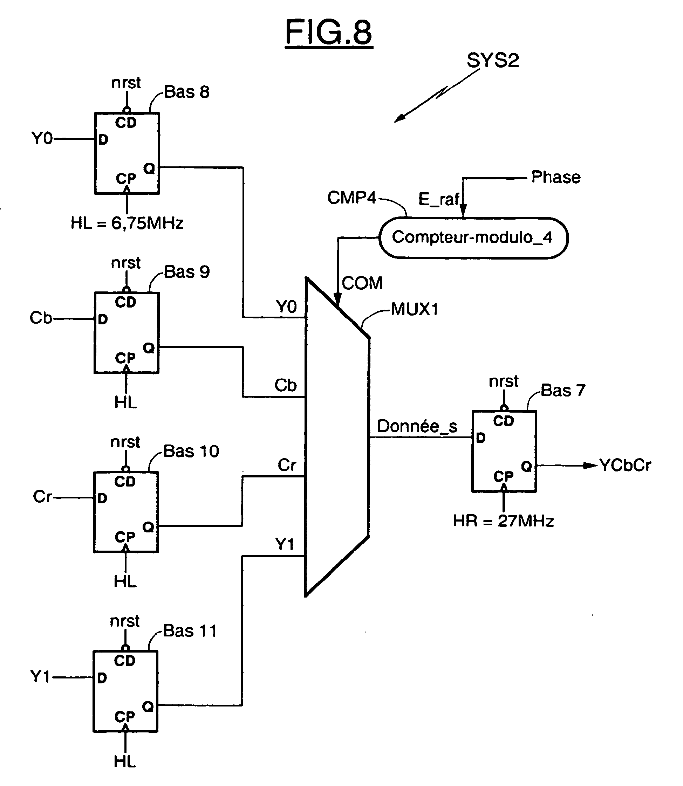

On se réfère à présent à la figure 8. Le système SYS 2 représente une deuxième utilisation du dispositif représenté sur la figure 2.

Le système SYS 2 est un système de multiplexage contrôlé de données utilisé, dans cet exemple, pour transmettre dans un ordre prédéterminé, des coefficients représentant la luminance et les chrominances bleues et rouges d'une application de vidéo numérique par exemple.

Le système SYS 2 comprend quatre bascules Bas 8, Bas 9, Bas 10 et Bas 11 en parallèle. Chacune des quatre bascules est commandée par un signal de remise à zéro nrst et est cadencée par le signal d'horloge lente HL qui est dans cet exemple égal à 6,75 MHz. Les quatre bascules Bas 8, Bas 9, Bas 10 et Bas 11 sont respectivement alimentées par les coefficients de la luminance Y0, de la chrominance bleue Cb, de la chrominance rouge Cr et de luminance Y1. Ils délivrent par leurs bornes de sortie Q les données qu'ils reçoivent sur leur borne d'entrée D en fonction du signal de l'horloge lente HL.

Ces données de sortie sont délivrées à un multiplexeur MUX1, commandé par un compteur modulo_4, CMP4. Le compteur modulo_4 CMP4 reçoit sur une entrée E_raf le signal logique Phase, délivré par le dispositif représenté sur la figure 2. Le signal Phase est destiné à commander le rafraîchissement du compteur modulo_4, CMP4. En fonction du signal de commande COM délivré par le compteur modulo-4 CMP4, le multiplexeur MUX 1 délivre en sortie dans un ordre les données Donnée_s correspondant aux plans Y0, Cb, Cr et Y1.

Les données Donnée_s sont délivrées sur l'entrée D d'une bascule Bas 7. La bascule Bas 7 est commandée par un signal de remise à zéro nrst et cadencée par le signal d'horloge rapide HR. Dans cet exemple, la fréquence du signal d'horloge rapide est de 27 MHz. La bascule Bas 7 délivre par sa borne de sortie Q, le flux de données YCBCR à la fréquence du signal de l'horloge rapide HR, c'est-à-dire 27 MHz.

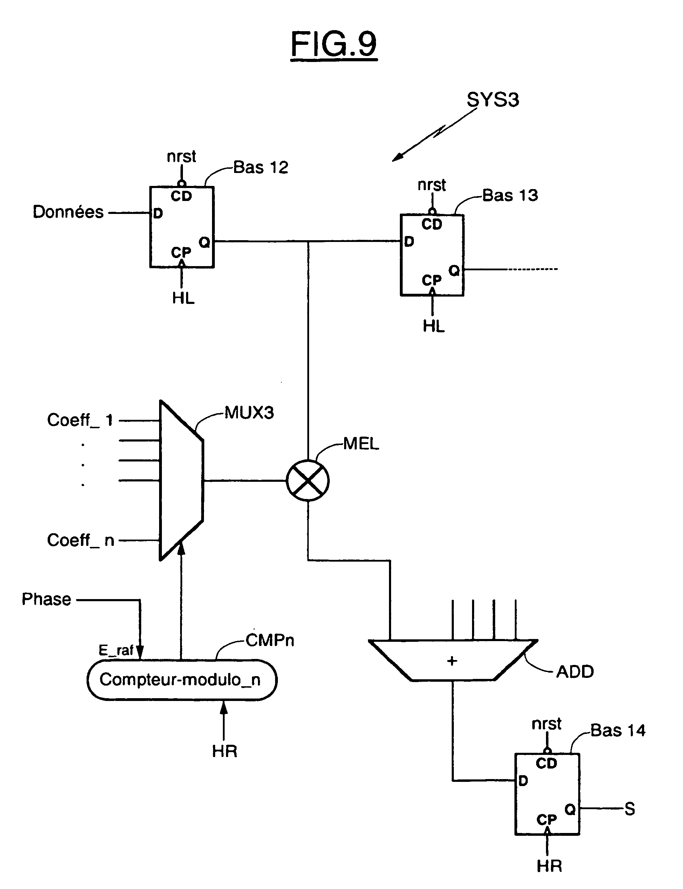

On se réfère à présent à la figure 9 qui représente un autre exemple d'utilisation du dispositif représenté sur la figure 2.

Le système SYS 3 de la figure 9 représente un système de multiplexage contrôlé de données. Le système SYS 3 comprend une première bascule Bas 12 commandée par un signal de remise à zéro nrst et cadencée par un signal d'horloge lente HL. La bascule Bas 12 reçoit en entrée des données Données, qu'elle délivre par sa borne de sortie Q à un mélangeur MEL. Le mélangeur MEL reçoit également en entrée des données issues d'un multiplexeur MUX 3. Le multiplexeur MUX 3 reçoit en entrée n coefficients Coeff_1, ..., Coeff_n.

En outre, le multiplexeur MUX 3 est commandé par un signal de sortie issu d'un compteur modulo_n, CMPn. Le compteur modulo_n CMPn est cadencé par le signal d'horloge rapide HR. En outre, il est commandé par le signal logique Phase, reçue sur son entrée E_raf et apte à commander le rafraîchissement du compteur modulo_n, CMPn. Ainsi, le multiplexeur MUX3 commandé par le compteur modulo_n CMPn, permet d'appliquer successivement les n coefficients, Coeff_1, ...Coeff_n, aux données délivrées par la bascule Bas 12. L'application des n coefficients se fait par l'intermédiaire du mélangeur MEL. Le signal de sortie du mélangeur MEL est délivré à un additionneur ADD. L'additionneur ADD peut également recevoir en entrée, parallèlement, d'autres données issues d'autres bascules, par exemple la bascule Bas 13, connectée en série avec la bascule Bas 12.

L'additionneur ADD délivre en sortie un signal résultant élaboré en additionnant les différentes données délivrées en entrée de l'additionneur ADD.

Le signal résultant délivré par l'additionneur ADD est transmis à une bascule de sortie Bas 14 commandée par un signal de remise à zéro nrst et cadencée par le signal d'horloge rapide HR. La bascule Bas 14 délivre alors en sortie un signal de sortie S à la fréquence du signal de l'horloge rapide HR. On note que dans cet exemple, la fréquence de l'horloge rapide HR est n fois plus élevée que la fréquence du signal de l'horloge lente HL, n étant le nombre de coefficients délivrés à l'entrée du multiplexeur MUX3.

## Revendications

1. Procédé de détection du positionnement relatif de deux signaux d'horloge, l'un de ces signaux d'horloge étant un signal d'horloge dite rapide (HR) et l'autre un signal d'horloge dite lente (HL), tel que la fréquence de l'horloge rapide (HR)soit n fois supérieure à la fréquence de l'horloge lente (HL), n étant un entier supérieur à 1, **caractérisé par le fait que** l'on génère, à partir des signaux d'horloge, un signal logique dit de phase (Phase) prenant une valeur logique prédéterminée lorsqu'un front montant du signal d'horloge rapide (HR) se situe à un emplacement prédéterminé de la période du signal d'horloge lente (HL), ladite génération du signal logique dit de phase (Phase) comprenant :
- un auto échantillonnage de l'un des signaux d'horloge de façon à obtenir un premier signal logique intermédiaire (Phase_aléatoire),
- un échantillonnage du premier signal logique intermédiaire à l'aide de l'autre signal d'horloge de façon à obtenir un second signal logique intermédiaire (Polarité),
- et une opération logique sur les deux signaux intermédiaires de façon à obtenir le signal logique dit de phase (Phase).

2. Procédé de détection selon la revendication 1, **caractérisé par le fait que** les fronts des deux signaux d'horloge sont sensiblement alignés.

3. Procédé selon la revendication 1 ou 2, **caractérisé par le fait que** l'opération logique est une opération « OU EXCLUSIF ».

4. Dispositif (Dis, Dis2) pour la détection du positionnement relatif de deux signaux d'horloge, l'un de ces signaux d'horloge étant un signal d'horloge dite rapide (HR) et l'autre un signal d'horloge dite lente (HL), tel que la fréquence de l'horloge rapide (HR) soit n fois supérieure à la fréquence de l'horloge lente (HL), n étant un entier supérieur à 1, **caractérisé par le fait qu'**il comprend des moyens de génération aptes à élaborer, à partir des signaux d'horloge, un signal logique dit de phase (Phase) prenant une valeur logique prédéterminée lorsqu'un front montant du signal d'horloge rapide (HR) se situe à un emplacement prédéterminé de la période du signal d'horloge lente (HL),lesdits moyens de génération comprenant :
- un premier élément séquentiel (Bas 1) dont la sortie (QN) est rebouclée sur l'entrée (D), cadencé par l'un des signaux d'horloge, et apte à délivrer un premier signal logique intermédiaire (Phase_aléatoire),
- un deuxième élément séquentiel (Bas 2) alimenté par le premier signal logique intermédiaire (Phase_aléatoire), cadencé par le signal issu de l'autre horloge, et apte à délivrer un deuxième signal logique intermédiaire (Polarité),
- un élément logique (XOR) connecté à la sortie des deux éléments séquentiels (Bas 1, Bas 2).

5. Dispositif selon la revendication 4, **caractérisé par le fait que** le premier et le deuxième élément séquentiel sont des bascules.

6. Dispositif selon l'une des revendications 5, **caractérisé par le fait que** l'élément logique est une porte logique « OU EXCLUSIF » (XOR).

7. Système (SYS) de transmission synchronisée de données **caractérisé par le fait qu**'il comprend :
- un sélecteur (SEL)
- un dispositif pour la détection du positionnement relatif de deux signaux d'horloge selon l'une des revendications 4 à 6,
- un élément séquentiel d'entrée (Bas 5) cadencée par l'un des signaux d'horloge et dont la sortie est rebouclée sur l'entrée par l'intermédiaire du sélecteur (SEL) commandé par le signal logique dit de phase (Phase) délivré par ledit dispositif de détection, ledit sélecteur (SEL) recevant également en entrée lesdites données à transmettre (Données),
- un élément séquentiel de sortie (Bas 6) recevant en entrée le signal délivré en sortie de l'élément séquentiel d'entrée (Bas 5) et cadencé par l'autre signal d'horloge.

8. Système (SYS 2) de multiplexage contrôlé de données, **caractérisé par le fait qu**'il comprend :
- un dispositif pour la détection du positionnement relatif de deux signaux d'horloge selon l'une des revendications 4 à 6,
- un multiplexeur (MUX1) et un compteur module-p (CMP4),
- p l'éléments séquentiels d'entrée (Bas 8,...,Bas 11) cadencés par le, signal d'horloge lente (HL) et respectivement connectés au multiplexeur (MUX1 **)** commandé par un signal de commande (COM) par l'intermédiaire du compteur modulo-p (CMP4), ledit compteur modulo-p (CMP4) étant cadencé par le signal d'horloge rapide (HR) et commandé par le signal logique dit de phase (Phase) délivré par ledit dispositif de détection,
- un élément séquentiel de sortie (Bas 7) cadencé par le signal d'horloge rapide et recevant en entrée le signal de sortie du multiplexeur (MUX1).

9. Système de filtres polyphasés (SYS 3), **caractérisé par le fait qu'**il comprend:
- un dispositif pour la détection du positionnement relatif de deux signaux d'horloge selon l'une des revendications 4 à 6,
- un élément séquentiel d'entrée (Bas 12) recevant des données d'entrée, cadencé par le signal de l'horloge lente (HL),
- un multiplexeur (MUX 3) destiné à recevoir en parallèle n coefficients prédéterminés (Coeff_1, ..., Coeff_n),
- un additonneur (ADD) ,
- un moyen de mélange (MEL) dont la sortie est connectée à l'entrée de l'additionneur (ADD) et apte à recevoir les n coefficients prédéterminés délivrés par le multiplexeur (MUX3),
- un compteur modulo-n (CMPn), commandé par le signal logique dit de phase (Phase) délivré par ledit dispositif de détection, et cadencé par le signal d'horloge rapide (HR), pour commander le multiplexeur (MUX3) de façon à ordonnancer la délivrance des n coefficients prédéterminés (Coeff_1, ..., Coeff_n),
- un élément séquentiel de sortie (Bas 14) connecté à la sortie du multiplexeur (MUX 3) et cadencé par le signal d'horloge rapide (HR).

## Claims

1. Method of detecting the relative positioning of two clock signals, one of these clock signals being a so-called fast clock signal (HR) and the other a so-called slow clock signal (HL), such that the frequency of the fast clock (HR) is n times greater than the frequency of the slow clock (HL), n being an integer greater than 1, **characterized in that** a so-called phase logic signal (Phase) taking a predetermined logic value when a rising edge of the fast clock signal (HR) is situated at a predetermined location of the period of the slow clock signal (HL) is generated from the clock signals, the said generation of the so-called phase logic signal (Phase) comprising:
- an autosampling of one of the clock signals so as to obtain a first intermediate logic signal (Phase_aleatoire),
- a sampling of the first intermediate logic signal with the aid of the other clock signal so as to obtain a second intermediate logic signal (Polarité),
- and a logic operation on the two intermediate signals so as to obtain the so-called phase logic signal (Phase).

2. Method of detection according to Claim 1, **characterized in that** the edges of the two clock signals are substantially aligned.

3. Method according to Claim 1 or 2, **characterized in that** the logic operation is an "EXCLUSIVE OR" operation.

4. Device (DIS, DIS2) for the detection of the relative positioning of two clock signals, one of these clock signals being a so-called fast clock signal (HR) and the other a so-called slow clock signal (HL), such that the frequency of the fast clock (HR) is n times greater than the frequency of the slow clock (HL), n being an integer greater than 1, **characterized in that** it comprises generating means able to formulate, from the clock signals, a so-called phase logic signal (Phase) taking a predetermined logic value when a rising edge of the fast clock signal (HR) is situated at a predetermined location of the period of the slow clock signal (HL), the said generating means comprising:
- a first sequential element (Bas 1) whose output (QN) is looped back to the input (D), regulated by one of the clock signals, and able to deliver a first intermediate logic signal (Phase_aléatoire),
- a second sequential element (Bas 2) fed by the first intermediate logic signal (Phase_aleatoire), regulated by the signal arising from the other clock, and able to deliver a second intermediate logic signal (Polarité),
- a logic element (XOR) connected to the output of the two sequential elements (Bas 1, Bas 2).

5. Device according to Claim 4, **characterized in that** the first and the second sequential element are flip-flops.

6. Device according to one of Claims 5, **characterized in that** the logic element is an "EXCLUSIVE OR" (XOR) logic gate.

7. System (SYS) for synchronizing transmission of data **characterized in that** it comprises:
- a selector (SEL),
- a device for the detection of the relative positioning of two clock signals according to one of Claims 4 to 6,
- a sequential input element (Bas 5) regulated by one of the clock signals and the output of which is looped back to the input by way of the selector (SEL) controlled by the so-called phase logic signal (Phase) delivered by the said detection device, the said selector (SEL) also receiving as input said data to be transmitted (Données),
- a sequential output element (Bas 6) receiving as an input the signal delivered as output from the sequential input element (Bas 5) and regulated by the other clock signal.

8. System (SYS 2) for controlled multiplexing of data, **characterized in that** it comprises:
- a device for the detection of the relative positioning of two clock signals according to one of Claims 4 to 6,
- a multiplexor (MUX1) and a counter modulo-p (CMP4),
- p sequential input elements (Bas 8, ..., Bas 11) regulated by the slow clock signal (HL) and respectively connected to the multiplexer (MUX1) controlled by a control signal (COM) by way of a counter modulo-p (CMP4), the said counter modulo-p (CMP4) being regulated by the fast clock signal (HR) and controlled by the so-called phase logic signal (Phase) delivered by the said detection device,
- a sequential output element (Bas 7) regulated by the fast clock signal and receiving as input the output signal of the multiplexer (MUX1).

9. System of polyphase filters (SYS 3), **characterized in that** it comprises:
- a device for the detection of the relative positioning of two clock signals according to one of Claims 4 to 6,
- a sequential input element (Bas 12) receiving input data, and regulated by the slow clock signal (HL),
- a multiplexer (MUX 3) intended to receive in parallel n predetermined coefficients (Coeff_1, ..., Coeff_n),
- an adder (ADD),
- a mixing means (MEL) whose output is connected to the input of the adder (ADD) and able to receive the n predetermined coefficients delivered by the multiplexer (MUX3),
- a counter modulo-n (CMPn), controlled by the phase logic signal (Phase) delivered by the said detection device, and regulated by the fast clock signal (HR), so as to control the multiplexer (MUX3) in such a way as to order the delivery of the n predetermined coefficients (Coeff_1, ..., Coeff_n),
- a sequential output element (Bas 14) connected to the output of the multiplexer (MUX 3) and regulated by the fast clock signal (HR).

## Patentansprüche

1. Verfahren zur Erfassung der relativen Positionierung von zwei Taktsignalen, wobei eines dieser Taktsignale ein Signal eines so genannten schnellen Taktgebers (HR) und das andere ein Signal eines so genannten langsamen Taktgebers (HL) ist, derart, dass die Frequenz des schnellen Taktgebers (HR) n mal höher ist als die Frequenz des langsamen Taktgebers (HL), wobei n eine ganze Zahl größer als 1 ist, **dadurch gekennzeichnet, dass** ausgehend von den Taktsignalen ein Phasensignal (Phase) genanntes logisches Signal erzeugt wird, das einen vorbestimmten logischen Wert annimmt, wenn eine steigende Flanke des Signals des schnellen Taktgebers (HR) sich an einer vorbestimmten Stelle der Periode des Signals des langsamen Taktgebers (HL) befindet, wobei die Erzeugung des Phasensignal (Phase) genannten logischen Signals aufweist:
- eine Selbstabtastung eines der Taktsignale, um ein erstes logisches Zwischensignal (Phase_aleatoire) zu erhalten,
- eine Abtastung des ersten logischen Zwischensignals mit Hilfe des anderen Taktsignals, um ein zweites logisches Zwischensignal (Polarité) zu erhalten,
- und eine logische Operation an den zwei Zwischensignalen, um das Phasensignal (Phase) genannte logische Signal zu erhalten.

2. Erfassungsverfahren nach Anspruch 1, **dadurch gekennzeichnet, dass** die Flanken der zwei Taktsignale im Wesentlichen fluchtend ausgerichtet sind.

3. Verfahren nach Anspruch 1 oder 2, **dadurch gekennzeichnet, dass** die logische Operation eine "EXKLUSIV-ODER"-Operation ist.

4. Vorrichtung (DIS, DIS2) zur Erfassung der relativen Positionierung von zwei Taktsignalen, wobei eines dieser Taktsignale ein Signal eines so genannten schnellen Taktgebers (HR) und das andere ein Signal eines so genannten langsamen Taktgebers (HL) ist, derart, dass die Frequenz des schnellen Taktgebers (HR) n mal höher ist als die Frequenz des langsamen Taktgebers (HL), wobei n eine ganze Zahl größer als 1 ist, **dadurch gekennzeichnet, dass** sie Erzeugungsmittel aufweist, die in der Lage sind, ausgehend von den Taktsignalen ein Phasensignal (Phase) genanntes logisches Signal zu erarbeiten, das einen vorbestimmten logischen Wert annimmt, wenn eine steigende Flanke des Signals des schnellen Taktgebers (HR) sich an einer vorbestimmten Stelle der Periode des Signals des langsamen Taktgebers (HL) befindet, wobei die Erzeugungsmittel aufweisen:
- ein erstes sequentielles Element (Bas 1), dessen Ausgang (QN) an den Eingang (D) rückgekoppelt ist, von einem der Taktsignale getaktet wird und in der Lage ist, ein erstes logisches Zwischensignal (Phase_aleatoire) zu liefern,
- ein zweites sequentielles Element (Bas 2), das mit dem ersten Zwischensignal (Phase_aleatoire) gespeist wird, von dem von dem anderen Taktgeber stammenden Signal getaktet wird und in der Lage ist, ein zweites logisches Zwischensignal (Polarité) zu liefern,
- ein logisches Element (XOR), das mit dem Ausgang der zwei sequentiellen Elemente (Bas 1, Bas 2) verbunden ist.

5. Vorrichtung nach Anspruch 4, **dadurch gekennzeichnet, dass** das erste und das zweite sequentielle Element Kippstufen sind.

6. Vorrichtung nach einem der Ansprüche 5, **dadurch gekennzeichnet, dass** das logische Element ein logisches "EXKLUSIV-ODER"-Glied (XOR) ist.

7. System (SYS) zur synchronisierten Datenübertragung, **dadurch gekennzeichnet, dass** es aufweist:
- einen Wählschalter (SEL),
- eine Vorrichtung zur Erfassung der relativen Positionierung von zwei Taktsignalen nach einem der Ansprüche 4 bis 6,
- ein sequentielles Eingangselement (Bas 5), das von einem der Taktsignale getaktet wird und dessen Ausgang an den Eingang über den Wählschalter (SEL) rückgekoppelt wird, der von dem Phasensignal (Phase) genannten logischen Signal gesteuert wird, das von der Erfassungsvorrichtung geliefert wird, wobei der Wählschalter (SEL) ebenfalls am Eingang die zu übertragenden Daten (Données) empfängt,
- ein sequentielles Ausgangselement (Bas 6), das am Eingang das am Ausgang des sequentiellen Eingangselements (Bas 5) gelieferte Signal empfängt und vom anderen Taktsignal getaktet wird.

8. System (SYS2) zur kontrollierten Datenmultiplexierung, **dadurch gekennzeichnet, dass** es aufweist:
- eine Vorrichtung zur Erfassung der relativen Positionierung von zwei Taktsignalen nach einem der Ansprüche 4 bis 6,
- einen Multiplexer (MUX1) und einen Modulo-p-Zähler (CMP4),
- p sequentielle Eingangselemente (Bas 8, ..., Bas 11), die vom Signal des langsamen Taktgebers (HL) getaktet werden und jedes mit dem Multiplexer (MUX1) verbunden sind, der über einen Modulo-p-Zähler (CMP4) mit einem Steuersignal (COM) gesteuert wird, wobei der Modulo-p-Zähler (CMP4) von dem Signal des schnellen Taktgebers (HR) getaktet und von dem Phasensignal (Phase) genannten logischen Signal gesteuert wird, das von der Erfassungsvorrichtung geliefert wird,
- ein sequentielles Ausgangselement (Bas 7), das von dem Signal des schnellen Taktgebers getaktet wird und am Eingang das Ausgangssignal des Multiplexers (MUX1) empfängt.

9. System von Polyphasenfiltern (SYS3), **dadurch gekennzeichnet, dass** es aufweist:
- eine Vorrichtung zur Erfassung der relativen Positionierung von zwei Taktsignalen nach einem der Ansprüche 4 bis 6,
- ein sequentielles Eingangselement (Bas 12), das Eingangsdaten empfängt und von dem Signal des langsamen Taktgebers (HL) getaktet wird,
- einen Multiplexer (MUX3), der dazu bestimmt ist, parallel n vorbestimmte Koeffizienten (Coeff_1, ..., Coeff_n) zu empfangen,
- ein Addierglied (ADD),
- eine Mischeinrichtung (MEL), deren Ausgang mit dem Eingang des Addierglieds (ADD) verbunden ist und die in der Lage ist, die vom Multiplexer (MUX3) gelieferten n vorbestimmten Koeffizienten zu empfangen,
- einen Modulo-n-Zähler (CMPn), der von dem Phasensignal (Phase) genannten logischen Signal gesteuert wird, das von der Erfassungsvorrichtung geliefert wird, und vom Signal des schnellen Taktgebers (HR) getaktet wird, um den Multiplexer (MUX3) so zu steuern, dass die Lieferung der n vorbestimmten Koeffizienten (Coeff_1, ..., Coeff_n) geordnet wird,
- ein sequentielles Ausgangselement (Bas 14), das mit dem Ausgang des Multiplexers (MUX3) verbunden ist und von dem Signal des schnellen Taktgebers (HR) getaktet wird.
